# EUROPÄISCHE PATENTSCHRIFT

(11) **EP 2 405 576 B1**
(45) Veröffentlichungstag und Bekanntmachung des Hinweises auf die Patenterteilung: **13.02.2013**
(21) Anmeldenummer: 11172661.8
(22) Anmeldetag: 05.07.2011
(51) Int. Cl.: H03K 17/96, D06F 39/00

(54) **Steuergerät für ein Haushaltsgerät**
Control unit for a household appliance
Appareil de commande pour un appareil ménager

(30) Priorität: 07.07.2010 DE 102010031079
(43) Veröffentlichungstag der Anmeldung: 11.01.2012
(73) Patentinhaber: E.G.O. Control Systems GmbH, 72336 Balingen (DE)
(72) Erfinder: Streifler, Rolf, 72367 Weilen (DE); Bayer, Ewald, 72358 Dormettingen (DE); Heicks, Wilhelm, 72351 Geislingen (DE)
(74) Vertreter: Patentanwälte Ruff, Wilhelm, Beier, Dauster & Partner

(56) Entgegenhaltungen:
- WO-A1-2004/040762
- DE-A1-102005 010 517
- DE-A1-102006 062 393
- FR-A1- 2 417 576

## Beschreibung

Die Erfindung betrifft ein Steuergerät für ein Haushaltsgerät.

Derartige Steuergeräte weisen üblicherweise Bedienelemente auf, mittels derer eine Bedienersteuerung des Haushaltsgeräts ermöglicht wird. Die Bedienelemente können einen berührungsempfindlichen Sensor, beispielsweise einen kapazitiven Sensor, umfassen. Ein solcher Sensor wird z.B in WO 2004/040762 A1 enthüllt.

### Aufgabe und Lösung

Der Erfindung liegt die Aufgabe zugrunde, ein Steuergerät mit einem berührungsempfindlichen Sensor für ein Haushaltsgerät zur Verfügung zu stellen, welches einfach und kostengünstig herstellbar ist.

Die Erfindung löst diese Aufgabe durch ein Steuergerät nach Anspruch 1. Bevorzugte Ausführungsformen sind Gegenstand der Unteransprüche, deren Wortlaut hiermit durch Bezugnahme zum Inhalt der Beschreibung gemacht wird.

Das erfindungsgemäße Steuergerät für ein Haushaltsgerät weist auf: ein Gehäuse, beispielsweise aus Kunststoff, mit einer einem Bediener zuzuwendenden Frontseite mit mindestens einer Öffnung, eine Leiterplatte, die senkrecht zur Frontseite innerhalb des Gehäuses gehalten ist und die mindestens eine Sensorkontaktfläche aufweist, und mindestens einen berührungsempfindlichen Sensor mit einem elektrisch leitfähigen Kunststoffformkörper. Der berührungsempfindliche Sensor umfasst gegebenenfalls noch weitere, herkömmliche Komponenten, beispielsweise elektrische Bauelemente, einen Mikroprozessor zur Signalauswertung, etc. Der, insbesondere einstückige, Kunststoffformkörper umfasst einen Sensorflächenabschnitt, der auf einer einem Benutzer zuzuwendenden Seite der Frontseite des Gehäuses angeordnet ist und der eine sensorwirksame Fläche bildet, einen streifenförmigen bzw. leiterbahnförmigen Verbindungsabschnitt, einen Durchtrittsabschnitt, der durch die Öffnung der Frontseite des Gehäuses hindurchtritt, und einen Kontaktabschnitt, der elektrisch mit der Sensorkontaktfläche der Leiterplatte kontaktiert ist. Der Kunststoffformkörper ist bevorzugt als weichelastischer, formveränderbarer leitfähiger Körper gebildet, beispielsweise als so genanntes Leitgummi. Der Sensorflächenabschnitt kann beispielsweise als kreisrunde, ovale oder rechteckige, insbesondere quadratische, Fläche gebildet sein mit einem Flächeninhalt von beispielsweise ca. 2cm². Der Kunststoffformkörper ermöglicht eine einfache Verwirklichung des berührungsempfindlichen Sensors ohne zusätzliche Bauelemente, die zwischen den Sensorflächenabschnitt und die Sensorkontaktfläche der Leiterplatte einzuschleifen sind.

In einer Weiterbildung grenzt der streifenförmige Verbindungsabschnitt an den Sensorflächenabschnitt und verläuft auf der dem Benutzer zuzuwendenden Seite der Frontseite des Gehäuses, der Durchtrittsabschnitt grenzt an den Verbindungsabschnitt und der Kontaktabschnitt grenzt an den Durchtrittsabschnitt.

Alternativ grenzt der Durchtrittsabschnitt an den Sensorflächenabschnitt, der streifenförmige Verbindungsabschnitt grenzt an den Durchtrittsabschnitt und verläuft auf einer dem Benutzer abzuwendenden Seite der Frontseite des Gehäuses und der Kontaktabschnitt grenzt an den Verbindungsabschnitt.

In einer Weiterbildung umfasst das Steuergerät ein Mehrkomponentenspritzgussformteil, wobei das Gehäuse und der Kunststoffformkörper als Komponenten des Mehrkomponentenspritzgussformteils gebildet sind. Dies reduziert Montagekosten.

In einer Weiterbildung ist der berührungsempfindliche Sensor ein kapazitiver Sensor, wobei der Sensorflächenabschnitt eine der beiden Kondensatorplatten des kapazitiven Sensors bildet.

In einer Weiterbildung weist das Gehäuse ein Gegenlager auf, wobei der Kontaktabschnitt des Kunststoffformkörpers zwischen der Leiterplatte und dem Gegenlager eingespannt ist.

In einer Weiterbildung tritt der Durchtrittsabschnitt derart durch die Öffnung der Frontseite des Gehäuses hindurch, dass die Öffnung, insbesondere gegenüber Spritzwasser, abgedichtet ist.

### Kurzbeschreibung der Zeichnungen

Vorteilhafte Ausführungsformen der Erfindung sind in den Zeichnungen schematisch dargestellt und werden nachfolgend beschrieben. Hierbei zeigt:
- Fig. 1: ein Steuergerät für ein Haushaltsgerät in perspektivischer Darstellung,
- Fig. 2: eine Darstellung eines Schnitts entlang einer Ebene E des in Fig. 1 gezeigten Steuergeräts und
- Fig. 3: eine Darstellung einer Alternative zu der in Fig. 2 gezeigten Ausführungsform.

### Detaillierte Beschreibung der Zeichnungen

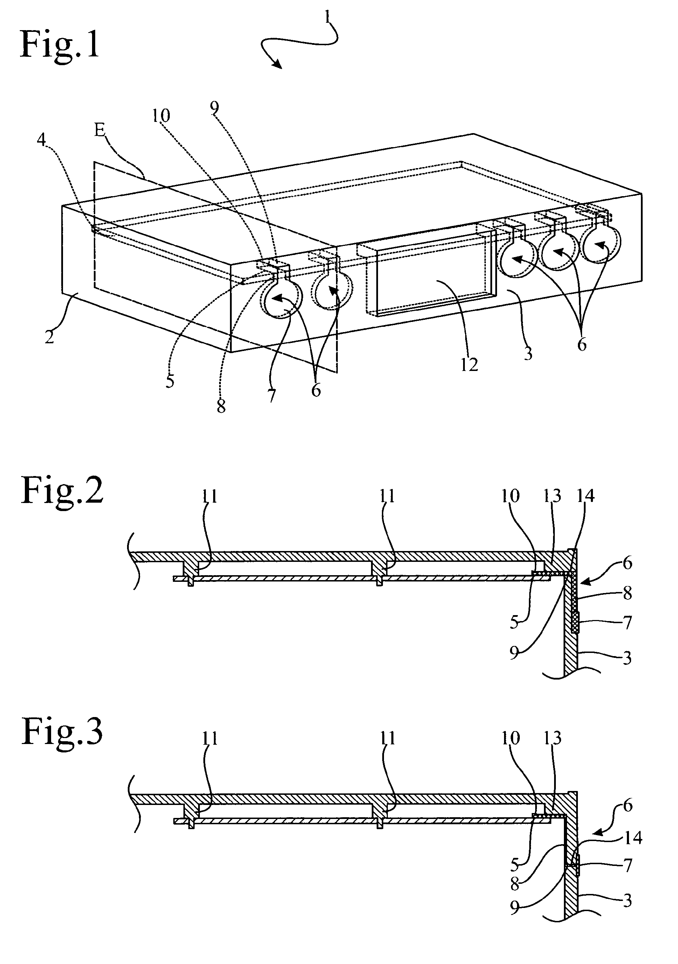

Fig. 1 zeigt ein Steuergerät 1 für ein Haushaltsgerät, beispielsweise einen Kühlschrank, in perspektivischer Darstellung.

Das Steuergerät 1 umfasst ein Kunststoffgehäuse 2 mit einer einem Bediener zuzuwendenden Frontseite 3 mit fünf Öffnungen 14 (siehe Figuren 2 und 3), in die flüssigkeitsdichtend jeweils elektrisch leitende Kunststoffformkörper 6 eingesetzt sind, die Bestandteil von berührungsempfindlichen kapazitiven Sensoren sind, eine Leiterplatte 4, die senkrecht zur Frontseite 3 innerhalb des Gehäuses 2 mittels Befestigungsmitteln 11 (siehe Figuren 2 und 3) gehalten ist, wobei die Befestigungsmittel 11 an einer Gehäuseoberseite angeordnet sind, und die Sensorkontaktflächen 5 (siehe Figuren 2 und 3) auf einer Leiterplattenoberseite in Form von metallisierten Flächen aufweist, und eine herkömmliche Anzeige 12, die eine zugehörige Gehäuseausnehmung ausfüllt.

Die Frontseite 3 wird bei einem Einbau des Steuergeräts 1 in das Haushaltsgerät durch eine nicht gezeigte, elektrisch isolierende Blende oder Folie zumindest im Bereich der Kunststoffkörper 6 abgedeckt. Die Blende bzw. Folie kann als Dielektrikum wirken.

Bezugnehmend auf die Figuren 1 bis 3 sind die elektrisch leitfähigen Kunststoffformkörper 6 jeweils aus einem kreisrunden, sensorwirksamen Sensorflächenabschnitt 7, der auf der Frontseite 3 des Gehäuses 2 angeordnet und leicht erhaben ist, einem streifenförmigen Verbindungsabschnitt 8, einem Durchtrittsabschnitt 9, der durch die Öffnung 14 der Frontseite 3 des Gehäuses 2 hindurchtritt, und einem Kontaktabschnitt 10 gebildet, der elektrisch mit der zugehörigen Sensorkontaktfläche 5 der Leiterplatte 4 kontaktiert ist. Der Kunststoffformkörper 6 ist bevorzugt einstückig gebildet.

Bei der in Fig. 2 gezeigten Ausführungsform grenzt der streifenförmige Verbindungsabschnitt 8 an den Sensorflächenabschnitt 7 und verläuft auf der dem Benutzer zuzuwendenden Seite der Frontseite 3. Der Durchtrittsabschnitt 9 grenzt an den Verbindungsabschnitt 8 und der Kontaktabschnitt 10 grenzt an den Durchtrittsabschnitt 9. Der Sensorflächenabschnitt 7 und der Verbindungsabschnitt 8 sind in eine korrespondierende Vertiefung auf der Frontseite 3 eingesetzt. Des Weiteren können nicht gezeigte, konstruktive Maßnahmen in bzw. an der Frontseite 3 getroffen sein, die bei einer Montage der Steuereinheit 1 bzw. der Frontseite 3 hinter einer Blende des Haushaltsgeräts ein Federn des Kunststoffformkörpers 6 derart ermöglichen, dass Toleranzen, beispielsweise in einer Dicke der Abschnitte 7 und 8, ausgeglichen werden, um ein Durchdrücken der Abschnitte 7 und 8 durch die Blende zu vermeiden.

Bei der in Fig. 3 gezeigten Ausführungsform grenzt der Durchtrittsabschnitt 9 an den Sensorflächenabschnitt 7, der streifenförmige Verbindungsabschnitt 8 grenzt an den Durchtrittsabschnitt 9 und verläuft auf einer dem Benutzer abzuwendenden Seite der Frontseite 3 und der Kontaktabschnitt 10 grenzt an den Verbindungsabschnitt 8. Der Sensorflächenabschnitt 7 ist in eine korrespondierende Vertiefung auf der Frontseite 3 eingesetzt. Auch hier können wie bei der in Fig. 2 gezeigten Ausführungsform konstruktive Maßnahmen in der Frontseite 3 vorgesehen sein, die ein Durchdrücken des Abschnitts 7 durch die Blende vermeiden.

Das Gehäuse 2 und die Kunststoffformkörper 6 können als Komponenten eines Mehrkomponentenspritzgussformteils gebildet sein, wodurch ein Einsetzschritt der Kunststoffformkörper 6 bzw. von deren Durchtrittsabschnitten 9 in die zugehörigen Öffnungen 14 des Gehäuses 2 bei einer Montage des Steuergeräts 1 entfällt.

Die Kunststoffformkörper 6 sind Bestandteil herkömmlicher kapazitiver Sensoren, wobei ein jeweiliger Sensorflächenabschnitt 7 eine von zwei Kondensatorplatten des kapazitiven Sensors bildet. Die kapazitiven Sensoren umfassen weitere, nicht gezeigte, herkömmliche Elemente, wie beispielsweise elektrische Bauelemente und einen Mikroprozessor.

Das Gehäuse 2 weist ein Gegenlager 13 auf, wobei der Kontaktabschnitt 10 des Kunststoffformkörpers 6 zwischen der Leiterplatte 4 bzw. deren Sensorkontaktfläche 5 und dem Gegenlager 13 eingespannt ist, um eine zuverlässige und niederohmige elektrische Verbindung des Kunststoffformkörpers 6 mit der Sensorkontaktfläche 5 der Leiterplatte sicherzustellen.

Die Sensorkontaktflächen 5 in Form von metallisierten Flächen auf der Oberseite der Leiterplatte 4 können alternativ oder zusätzlich auch auf der Unterseite der Leiterplatte 4 oder auf einer der Frontseite 3 des Gehäuses 2 zuzuwendenden Seite der Leiterplatte 4 angeordnet sein, wobei für diesen Fall die Form der Kunststoffkörper 6 und/oder der Ort der Öffnungen 14 im Gehäuse 2 anzupassen sind.

Das in den Ausführungsformen gezeigte Steuergerät 1 mit berührungsempfindlichen Sensoren ist einfach und kostengünstig herstellbar, da der Kunststoffkörper 6 sowohl Teil des kapazitiven Sensorelements ist als auch Signalleitungsfunktionen bis zur Leiterplatte 4 erfüllt, wodurch weitere Signalleitungselemente entfallen können.

## Patentansprüche

1. Steuergerät (1) für ein Haushaltsgerät, aufweisend:
- ein Gehäuse (2) mit einer Frontseite (3) mit mindestens einer Öffnung (14),
- eine Leiterplatte (4), die senkrecht zur Frontseite innerhalb des Gehäuses (2) gehalten ist und die mindestens eine Sensorkontaktfläche (5) aufweist, und
- mindestens einen berührungsempfindlichen Sensor mit
- einem elektrisch leitfähigen Kunststoffformkörper (6), der
- einen Sensorflächenabschnitt (7) aufweist, der auf einer einem Benutzer zuzuwendenden Seite der Front-seite (3) des Gehäuses (2) angeordnet ist,
- einen streifenförmigen Verbindungsabschnitt (8) aufweist,
- einen Durchtrittsabschnitt (9) aufweist, der durch die Öffnung der Frontseite (3) des Gehäuses (2) hindurchtritt, und
- einen Kontaktabschnitt (10) aufweist, der elektrisch mit der Sensorkontaktfläche (5) der Leiterplatte (4) kontaktiert ist.

2. Steuergerät nach Anspruch 1, **dadurch gekennzeichnet, dass**
- der streifenförmige Verbindungsabschnitt (8) an den Sensorflächenabschnitt (7) angrenzt und auf der dem Benutzer zuzuwendenden Seite der Frontseite des Gehäuses (2) verläuft,
- der Durchtrittsabschnitt (9) an den Verbindungsabschnitt (8) angrenzt und
- der Kontaktabschnitt (10) an den Durchtrittsabschnitt (9) angrenzt.

3. Steuergerät nach Anspruch 1, **dadurch gekennzeichnet, dass**
- der Durchtrittsabschnitt (9) an den Sensorflächenabschnitt (7) angrenzt,
- der streifenförmige Verbindungsabschnitt (8) an den Durchtrittsabschnitt (9) angrenzt und auf einer dem Benutzer abzuwendenden Seite der Frontseite des Gehäuses (2) verläuft und
- der Kontaktabschnitt (10) an den Verbindungsabschnitt (8) angrenzt.

4. Steuergerät nach einem der vorhergehenden Ansprüche, **gekennzeichnet durch** ein Mehrkomponentenspritzgussformteil, wobei das Gehäuse (2) und der Kunststoffformkörper (6) als Komponenten des Mehrkomponentenspritzgussformteils gebildet sind.

5. Steuergerät nach einem der vorhergehenden Ansprüche, **dadurch gekennzeichnet, dass** der berührungsempfindliche Sensor ein kapazitiver Sensor ist, wobei der Sensorflächenabschnitt (7) eine Kondensatorplatte des kapazitiven Sensors bildet.

6. Steuergerät nach einem der vorhergehenden Ansprüche, **dadurch gekennzeichnet, dass** das Gehäuse (2) ein Gegenlager (13) aufweist, wobei der Kontaktabschnitt (10) des Kunststoffformkörpers zwischen der Leiterplatte (4) und dem Gegenlager (13) eingespannt ist.

7. Steuergerät nach einem der vorhergehenden Ansprüche, **dadurch gekennzeichnet, dass** der Durchtrittsabschnitt derart durch die Öffnung der Frontseite des Gehäuses hindurchtritt, dass die Öffnung abgedichtet ist.

## Claims

1. A control device (1) for a home appliance, comprising:
- a housing (2) having a front side (3) with at least one opening (14),
- a conductor plate (4) held inside the housing (2) perpendicularly with respect to the front side and which includes at least one sensor contact face (5), and
- at least one touch-sensitive sensor having
- an electrically conducting plastic molded part (6), comprising
- a sensor face section (7) arranged on a side of the front side (3) of the housing (2) that is to face a user,
- a strip-shaped connection section (8),
- a passage section (9) passing through the opening of the front side (3) of the housing (2), and
- a contact section (10) electrically contacted to the sensor contact face (5) of the conductor plate (4).

2. The control device according to claim 1, **characterized in that**
- the strip-shaped connection section (8) adjoins the sensor face section (7) and runs on the side of the front side of the housing (2) that is to face the user,
- the passage section (9) adjoins the connection section (8), and
- the contact section (10) adjoins the passage section (9).

3. The control device according to claim 1, **characterized in that**
- the passage section (9) adjoins the sensor face section (7),
- the strip-shaped connection section (8) adjoins the passage section (9) and runs on a side of the front side of the housing (2) that is to face away from a user, and
- the contact section (10) adjoins the connection section (8).

4. The control device according to any of the preceding claims, **characterized by** a multi-component injection-molded part, wherein the housing (2) and the plastic molded part (6) are formed as components of said multi-component injection-molded part.

5. The control device according to any of the preceding claims, **characterized in that** the touch-sensitive sensor is a capacitive sensor, wherein the sensor face section (7) forms a capacitor plate of the capacitive sensor.

6. The control device according to any of the preceding claims, **characterized in that** the housing (2) has a counter bearing (13), wherein the contact section (10) of the plastic molded part is clamped between the conductor plate (4) and the counter bearing (13).

7. The control device according to any of the preceding claims, **characterized in that** the passage section passes through the opening of the front side of the housing in such a way that the opening is sealed.

## Revendications

1. Appareil de commande (1) pour un appareil ménager, comportant .
- un carter (2) doté d'un côté avant (3) pourvu d'au moins une ouverture (14) ;
- une plaque conductrice (4) maintenue perpendiculairement au côté avant à l'intérieur du carter (2) et comportant l'au moins une surface de contact de capteur (5) ; et
- au moins un capteur tactile avec :
- un corps moulé en matière plastique (6) électriquement conducteur comportant :
- une section de surface de capteur (7) disposée sur un côté orienté vers l'utilisateur du côté avant (3) du carter (2) ;
- une section de jonction (8) en forme de bande ;
- une section traversante (9) passant au travers de l'ouverture du côté avant (3) du carter (2) ; et
- une section de contact (10) placée en contact électrique avec la surface de contact de capteur (5) de la plaque conductrice (4).

2. Appareil de commande selon la revendication 1, **caractérisé en ce que** :
- la section de jonction (8) en forme de bande est connexe à la section de surface de capteur (7) et s'étend sur le côté orienté vers l'utilisateur du côté avant du carter (2) ;
- la section traversante (9) est connexe à la section de jonction (8) ; et
- la section de contact (10) est connexe à la section traversante (9).

3. Appareil de commande selon la revendication 1, **caractérisé en ce que** :
- la section traversante (9) est connexe à la section de surface de capteur (7) ;
- la section de jonction (8) en forme de bande est connexe à la section traversante (9) et s'étend sur un côté détourné de l'utilisateur du côté avant du carter (2) ; et
- la section de contact (10) est connexe à la section de onction (8).

4. Appareil de commande selon l'une quelconque des revendications précédentes, **caractérisé par** la présence d'une pièce moulée par injection de plusieurs composants, le carter (2) et le corps moulé en matière plastique (6) étant formés sous forme de composants d'une pièce moulée par injection de plusieurs composants.

5. Appareil de commande selon l'une quelconque des revendications précédentes, **caractérisé en ce que** le capteur tactile est un capteur capacitif, la section de surface de capteur (7) formant une plaque de condensateur du capteur capacitif.

6. Appareil de commande selon l'une quelconque des revendications précédentes, **caractérisé en ce que** le carter (2) comporte un contre palier (13), la section de contact (10) du corps moulé en matière plastique étant enserrée entre la plaque conductrice (4) et le contre palier (13).

7. Appareil de commande selon l'une quelconque des revendications précédentes, **caractérisé en ce que** la section traversante passe de telle sorte à travers l'ouverture du côté avant du carter que l'ouverture est étanchéifiée.
